# EUROPÄISCHE PATENTANMELDUNG

(11) **EP 1 494 278 A1**
(43) Veröffentlichungstag der Anmeldung: **05.01.2005**
(21) Anmeldenummer: 03015213.6
(22) Anmeldetag: 04.07.2003
(51) Int. Cl.: H01L 23/40, H01L 25/07

(54) **Elektronisches Leistungsmodul mit Gummidichtung und entsprechendes Herstellungsverfahren**

(71) Anmelder: SIEMENS AKTIENGESELLSCHAFT, 80333 München (DE)
(72) Erfinder: Meier, Markus, 92286 Rieden (DE)

(57) **Zusammenfassung**

Das Volumen von Leistungsmodulen insbesondere für elektronische Motor-Steuergeräte soll reduziert werden. Dazu wird vorgeschlagen, dass mit Hilfe einer ringförmigen Gummidichtung (6) ein Raum zwischen Kühlelementen (7 bis 12) gebildet wird, in dem eine Halbleitereinrichtung (2) mit einer Vergussmasse (16) vergossen wird. Damit ist es möglich, die Halbleitereinrichtung (2) von beiden Seiten mit Kühlkörpern (9 bis 12) zu kühlen, so dass der Bauraum für das Leistungsmodul reduziert werden kann.

## Beschreibung

Die vorliegende Erfindung betrifft ein elektronisches Leistungsmodul, insbesondere für ein elektronisches Motor-Steuergerät zum Sanftanlauf von Motoren, mit einer ersten und einer zweiten Kühleinrichtung sowie einer Halbleitereinrichtung, die zwischen der ersten und der zweiten Kühleinrichtung angeordnet ist. Ferner betrifft die vorliegende Erfindung ein entsprechendes Verfahren zum Herstellen eines elektronischen Leistungsmoduls.

Ein gattungsgemäßes elektronisches Leistungsmodul ist als Bestandteil einer leistungselektronischen Einheit für den Sanftanlauf von Motoren bekannt. Die leistungselektronische Einheit umfasst hier eines oder mehrere elektronische Leistungsmodule, die für Kurzzeitbelastung ausgelegt sein müssen. Das elektronische Leistungsmodul dient zur Stromführung und - beeinflussung in einer Phase, d. h. je nachdem, ob ein einphasiges oder dreiphasiges Netz vorliegt, wird eine entsprechende Anzahl von elektronischen Leistungsmodulen benötigt.

Eine derartige leistungselektronische Einheit führt nur in der Anlaufphase des Motors Strom, der in der Betriebsphase von einem parallel geschalteten Schaltgerät übernommen wird.

Beim Sanftanlauf von Motoren beträgt der Strom nur einen Bruchteil des Direkteinschaltstroms des Motors. Typischerweise beträgt der Strom während des Anlaufs 25 % bis 75 % des Direkteinschaltstroms. Mit dem Sanftanlauf bei reduziertem Strom ergibt sich allerdings eine verlängerte Anlaufzeit des Motors im Vergleich zu der beim Direkteinschalten.

In der Anlaufphase entstehen in den Halbleitern der elektronischen Leistungsmodule sehr hohe Verlustleistungen. Durch geeignete Kombination aus Leistungsmodul beziehungsweise Leistungshalbleiter und Kühlkörper muss gewährleistet sein, dass die für die Halbleiter maximal zulässige Sperrschichttemperatur nicht überschritten wird, um deren Zerstörung zu vermeiden. Aufgrund beschränkter Platzverhältnisse im Schaltschrank ergibt sich zudem die Forderung, den Raumbedarf der elektronischen Leistungsmodule zu minimieren.

Bekannt ist eine nicht druckschriftlich belegbare Ausführungsform eines Thyristorleistungsmoduls, bei dem zwei einzelne Thyristoren antiparallel geschaltet und zwischen zwei symmetrische Kühlkörperhälften gepresst sind. Eine der beiden Kühlkörperhälften ist mittig geteilt und die beiden Teile sind mit einer flexiblen, elektrisch leitfähigen Verbindung verbunden. Dies ermöglicht eine flächige Pressung der Thyristorscheibenzellen auch bei unterschiedlicher Scheibenzellenhöhe. Die beiden Kühlkörperhälften dieses bekannten Leistungsteils, das sowohl für Kurzzeitbelastung als auch für Dauerbetrieb ausgelegt ist, sind Teil des Stromkreises und damit potentialbehaftet.

Die beim Sanftanlauf auftretende Kurzzeitbelastung verursacht in der Siliziumzelle eine sehr hohe Verlustleistung, die unmittelbar nach Belastungsbeginn zu einer Erwärmung der Scheibenzelle führt. Nach etwa 2 bis 5 Sekunden stellt sich eine konstante Temperaturdifferenz zwischen der Siliziumzelle und dem Kühlkörper ein, d. h. die Scheibenzelle befindet sich thermisch im eingeschwungenen Zustand, in dem nun nahezu die gesamte Verlustleistung zur Erwärmung des Kühlkörpers verwendet wird. Die Kühlung des Leistungsteils erfolgt hier mit einem Lüfter.

Darüber hinaus sind Siemens-Leistungsmodule der Baureihen 3RW30, 3RW22 und 3RW34 für Schaltleistungen unter 250 kW bekannt, die mit Thyristormodulen aufgebaut sind. Die Kühlung erfolgt wie auch bei den oben beschriebenen Leistungsmodulen mit Thyristorscheibenzellen auf einer Seite des Thyristors durch einen Aluminiumkühlkörper. Zwischen dem Thyristormodul und dem Kühler wird eine Wärmeleitpaste oder -folie eingebracht.

Des Weiteren sind aus der deutschen Patentanmeldung 100 22 341.9 des vorliegenden Anmelders ein weiterentwickelter Aufbau eines elektronischen Leistungsmoduls bekannt. Dieser zeichnet sich dadurch aus, dass zwei gehäuselose Halbleiterbauelemente, bestehend aus dem eigentlichen Halbleiterelement und Molybdänscheiben, zwischen zwei Kupferschienen eingespannt werden. Diese Anordnung wird in ein Gehäuse eingebaut und vergossen. Der Verguss dient zur Einhaltung der erforderlichen Spannungsabstände und zum Schutz vor schädlichen Umwelteinflüssen. Der Kühlkörper wird an einer Seite angebaut.

Der gesamte Aufbau der oben genannten elektronischen Leistungsmodule ist verhältnismäßig groß, was sich negativ auf die Abmessungen der Schaltgeräte bemerkbar macht.

Die Aufgabe der vorliegenden Erfindung besteht somit darin, die Abmessungen der elektronischen Leistungsmodule zu verringern und dabei die geforderte Kühlleistung aufrechtzuerhalten.

Erfindungsgemäß wird diese Aufgabe gelöst durch ein elektronisches Leistungsmodul, insbesondere für ein elektronisches Motor-Steuergerät zum Sanftanlauf von Motoren, mit einer ersten und einer zweiten Kühleinrichtung und einer Halbleitereinrichtung, die zwischen der ersten und der zweiten Kühleinrichtung angeordnet ist, wobei um die Halbleitereinrichtung ein elastischer Ringkörper angeordnet ist und wobei der Raum innerhalb des Ringkörpers, der teilweise von der ersten und zweiten Kühleinrichtung begrenzt wird und in dem sich die Halbleitereinrichtung befindet, vergossen ist.

Ferner ist erfindungsgemäß vorgesehen ein Verfahren zum Herstellen eines elektronischen Leistungsmoduls, insbesondere für ein elektronisches Motor-Steuergerät zum Sanftanlauf von Motoren, durch Anordnen einer Halbleitereinrichtung zwischen einer ersten und einer zweiten Kühleinrichtung, Anordnen eines elastischen Ringkörpers um die Halbleitereinrichtung, wobei sich ein Raum innerhalb des Ringkörpers, der teilweise von der ersten und zweiten Kühleinrichtung begrenzt wird und in dem sich die Halbleitereinrichtung befindet, ergibt, und Ausgießen des Raums mit einer Vergussmasse.

Der Erfindung liegt der Gedanke zugrunde, dass die leitenden Teile nicht wie bisher in ein dichtendes Gehäuse eingebaut und hierin mit Weichverguss vergossen werden. Dieser Aufbau erlaubt nämlich nur eine einseitige Kühlung. Vielmehr werden erfindungsgemäß die Funktionen des Gehäuses durch eine beispielsweise zwischen den verwendeten Kupferschienen eingespannte Gummidichtung realisiert.

Der erfindungsgemäße Aufbau ermöglicht besonders geringe Einbaumaße bei gleichzeitig hohen Schalthäufigkeiten. Dies wird zum einen durch die sehr geringen Wärmeübergangswiderstände vom Halbleiter beispielsweise über Wärmespeicher auf die beidseitig angebrachten Kühler erreicht. Vor allem wird die Reduzierung der Einbaumaße aber dadurch erreicht, dass durch die beidseitige Anbringung von Kühlern eine symmetrische Wärmeabfuhr von den Halbleitern erreicht wird. Durch das beidseitige Anbringen von Kühlern kann die Baubreite der Module im Idealfall nahezu halbiert werden. Als Folge der verringerten Baubreite des Leistungsmoduls kann die Baubreite der Schaltgeräte gering gehalten werden. Dies wirkt sich sehr vorteilhaft für eine optimale Ausnutzung eines Schaltschrankvolumens aus. Eine geringere Baubreite ist dabei höher zu bewerten als eine geringere Bautiefe oder -höhe.

Durch den erfindungsgemäßen Aufbau kann auf den Einsatz von aufwändigen Spannsystemen, wie sie in der oben genannten Patentanmeldung beschrieben sind, verzichtet werden, da der Kühlkörper die Stützfunktion der in der dortigen Patentanmeldung verwendeten Stahltraverse beziehungsweise Druckvorrichtung übernimmt. Als federndes Element können im Kühlkörper versenkte Tellerfederpakete dienen, wodurch auch die Bautiefe gering gehalten wird.

Vorzugsweise umfassen sowohl die erste als auch die zweite Kühleinrichtung jeweils mindestens einen Kühlkörper. Darüber hinaus können die Kühleinrichtungen aber auch jeweils Metallschienen zum unmittelbaren Wärmeabtransport von der Halbleitereinrichtung und zum elektrischen Kontaktieren der Halbleitereinrichtungen aufweisen.

Zur Vereinfachung der Montage und zur Reduzierung der Herstellungskosten können die Metallschiene und der Kühlkörper einer Kühleinrichtung einteilig geformt sein. Als Material hierfür eignet sich sowohl Kupfer als auch Aluminium.

Die Halbleitereinrichtung kann zwei elektrisch antiparallel geschaltete Halbleiterelemente, insbesondere Thyristoren, aufweisen. Dabei sind die Halbleiterelemente vorzugsweise als gehäuselose Halbleiterzellen ausgeführt, so dass ein unmittelbarer Wärmeabtransport und eine kleinere Bauform ermöglicht werden.

Der elastische Ringkörper zur Abdichtung, mit dem Fertigungstoleranzen der Kühleinrichtungen und der Halbleiterelemente ausgeglichen werden können, besteht vorzugsweise aus einem Gummimaterial.

Neben der Funktion des mechanischen Schutzes der Halbleiter und des Weichvergusses besitzt der elastische Ringkörper die genannte Funktion der Schaffung eines flüssigkeitsdichten Raums für die Vergussmasse durch Abdichten des Spalts zwischen den Kupferschienen beziehungsweise Kühleinrichtungen. Darüber hinaus besitzt der elastische Ringkörper die Funktion der Einhaltung der notwendigen minimalen Luft- und Kriechstrecken zwischen Netz- und Lastseite. Dies bedeutet, dass die Kühleinrichtungen beziehungsweise Kupferschienen auf unterschiedlichen Spannungspotentialen liegen und durch Gewährleistung eines vordefinierten Abstands Überschläge verhindert werden müssen. Daher sollte der Ringkörper in axialer Richtung eine im Wesentlichen konstante Abmessung aufweisen, so dass zwischen der ersten und der zweiten Kühleinrichtung eine vorgegebene Luft- oder Kriechstrecke gewährleistet ist.

Der Ringkörper weist darüber hinaus vorzugsweise eine Öffnung oder Aussparung auf, durch die Leitungen für eine Thyristorzündung durchgeführt sind und/oder durch die eine Vergussmasse eingebracht werden kann.

Die vorliegende Erfindung wird nun anhand der beigefügten Zeichnungen näher erläutert, in denen zeigen:
- FIG 1: eine Explosionszeichnung der Teile eines erfindungsgemäßen Leistungsmoduls;
- FIG 2: eine dreidimensionale Ansicht eines komplett montierten Leistungsmoduls;
- FIG 3: eine Seitenansicht des Leistungsmoduls von FIG 2;
- FIG 4: eine Querschnittsansicht des Leistungsmoduls von FIG 2; und
- FIG 5: eine Schaltungsanordnung mit erfindungsgemäßen Leistungsmodulen.

Die nachfolgend näher beschriebenen Ausführungsbeispiele stellen bevorzugte Ausführungsformen der vorliegenden Erfindung dar.

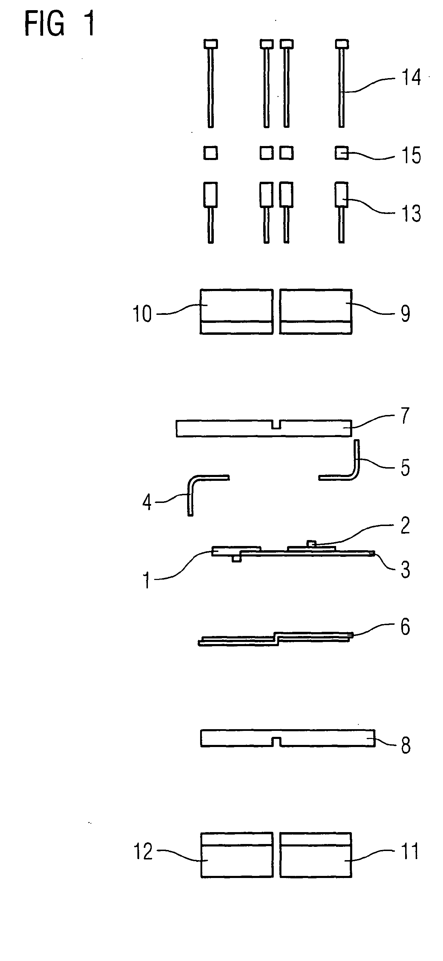

Die Einzelkomponenten eines erfindungsgemäßen elektronischen Leistungsmoduls sind in FIG 1 in einer Explosionsansicht skizziert. Zentrales Bauelement ist ein Halbleitermodul 1. Dieses besteht aus zwei Halbleiterzellen 2 und verfügt über einen Gateanschluss 3. Oberhalb des Halbleitermoduls 1 sind Leitungen 4 und 5 für die Hilfskathoden zum Zünden der Thyristoren angedeutet. In der Zeichnung unterhalb des Halbleitermoduls 1 befindet sich eine Gummidichtung 6, die das Halbleitermodul 1 im eingebauten Zustand an dessen Umfang umschließt.

FIG 1 zeigt weiterhin Kupferschienen 7 und 8, die in unmittelbaren Kontakt zu dem Halbleitermodul 1 gebracht werden, um dieses zu kontaktieren und die Verlustwärme bei Schaltzyklen zu puffern. An die Außenfläche jeder der Kupferschienen 7 und 8 werden jeweils zwei Kühlkörper 9, 10 und 11, 12 angeordnet. Zur Befestigung dieser Anordnung dienen Isolierhülsen 13, in die Schrauben 14 eingeführt werden. Als federndes Element dienen im jeweiligen Kühlkörper 9, 10 versenkte Tellerfederpakete 15. Auch diese Gestaltung dient zur Reduzierung des Volumens des Leistungsmoduls und insbesondere der Bautiefe.

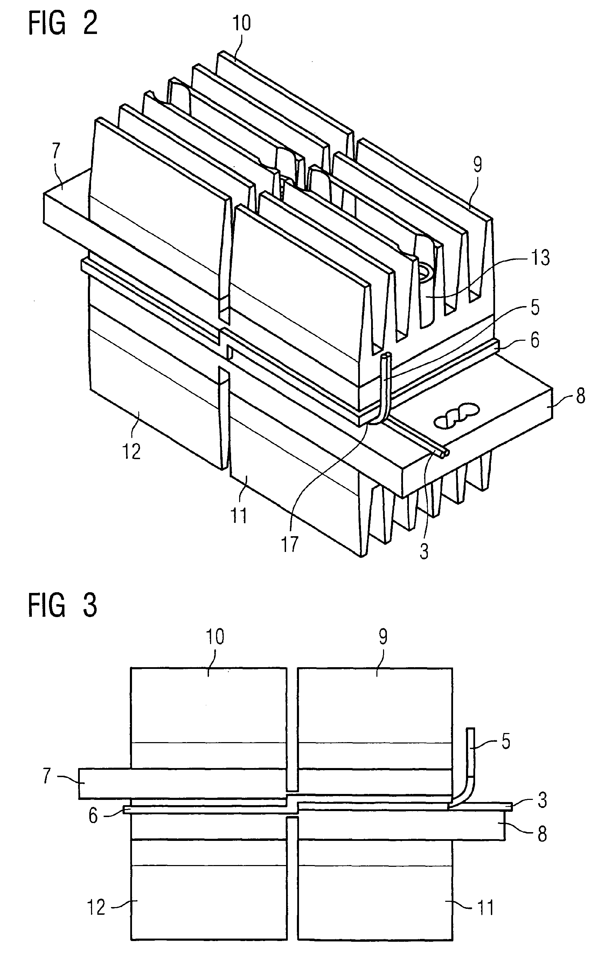

Das komplett montierte Leistungsmodul ist in FIG 2 in perspektivischer Ansicht wiedergegeben. Dort sind die meisten der im Zusammenhang mit FIG 1 beschriebenen Elemente ebenfalls zu erkennen. Das Halbleitermodul 1 ist jedoch in FIG 2 nicht zu erkennen, da es sich im Zwischenraum zwischen den Kühlkörpern 9, 10, 11 und 12 sowie der Gummidichtung 6 befindet.

Eine Seitenansicht des erfindungsgemäßen Leistungsmoduls ist in FIG 3 dargestellt. Hinsichtlich der einzelnen Komponenten wird wiederum auf FIG 2 beziehungsweise FIG 1 verwiesen.

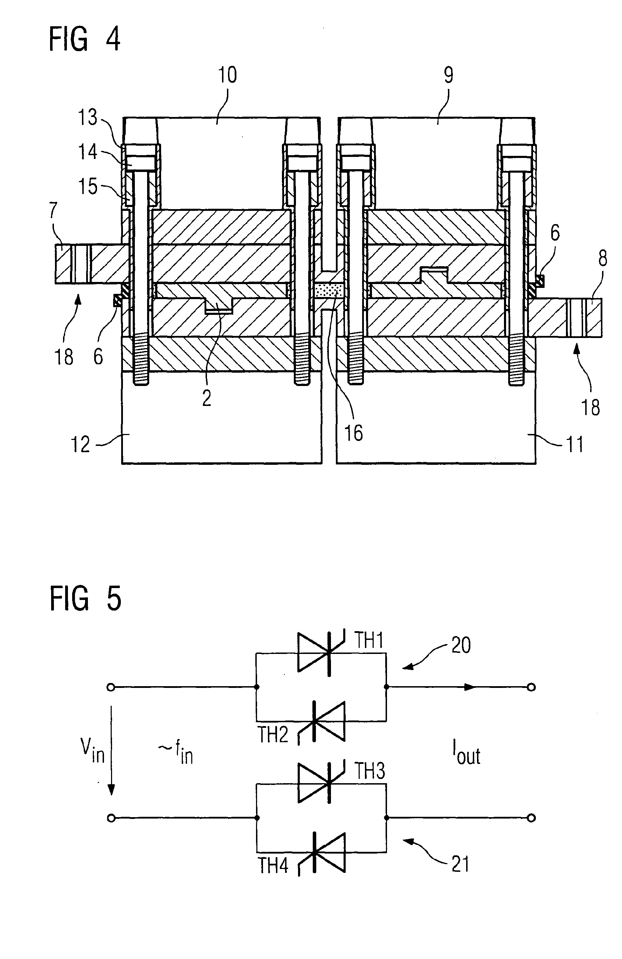

Ein Querschnitt durch die Seitenansicht von FIG 3 ist in FIG 4 wiedergegeben. Es ist gut zu erkennen, wie das Halbleitermodul 1 mit seinen Halbleiterzellen 2 in die Metall- beziehungsweise Kupferschienen 7, 8 eingebettet ist. Die Kupferschienen 7, 8 geben ihre Wärme an die jeweiligen Kühlkörper 9, 10, 11 und 12 ab. Die Kühlkörper bestehen üblicherweise aus Kupfer oder Aluminium. Falls die Metallschienen 7, 8 mit den Kühlkörpern 9, 10, 11 und 12 einteilig ausgestaltet sind, können weitere Wärmeübergangsstellen vermieden werden. Hierdurch können die Abmessungen wiederum reduziert und die Herstellungskosten gesenkt werden.

Die Halbleiterzellen 2, die in FIG 4 einteilig dargestellt sind, bestehen aus einer Siliziumscheibe, die in der Regel zwischen zwei Metallscheiben, welche beispielsweise aus Molybdän bestehen, eingebettet und mit einer Kontaktierung zur Anlegung eines Aktivierungsstromimpulses versehen ist (Gateleitung).

Der Raum zwischen den Metall- beziehungsweise Kupferschienen 7, 8 und der rechteckförmigen Gummiringdichtung 6, in dem sich das Halbleitermodul 1, beziehungsweise die Halbleiterzellen 2 befinden, ist mit einer Vergussmasse 16 vergossen. Dadurch werden die Anforderungen an Stabilität und Isolation erfüllt. Aus FIG 2 ist hierzu eine Öffnung 17 ersichtlich, durch die die Vergussmasse 16 in den freien Raum zwischen den Metallschienen 7, 8 und der Gummidichtung 6 eingebracht werden kann. Durch diese Öffnung 17 in der Gummidichtung 6 ragen die Anschlussleitungen 3 und 5.

Die Profilgebung der Gummidichtung 6 trägt dazu bei, dass die Kriechstrecke zwischen den beiden Metallschienen 7, 8, die auf unterschiedlichem Potential liegen, vergrößert wird. In die Metallschienen 7, 8 sind entsprechende Anschlüsse 18 zum elektrischen Kontaktieren eingeformt.

Mit Hilfe der Schrauben 14, der Isolierhülsen 13 und der Tellerfederpakete 15 werden die Kühlkörper 9, 10, 11 und 12 miteinander verschraubt.

FIG 5 zeigt schließlich ein elektrisches Schaltungsdiagramm zweier Leistungsmodule 20 und 21, die zu einem Vierpol verschaltet sind. Jedes dieser Leistungsmodule 20 beziehungsweise 21 entspricht dem in den vorhergehenden Figuren dargestellten Leistungsmodul. Das Schaltbild jedes Leistungsmoduls 20, 21 ist durch zwei elektrisch antiparallel geschaltete Thyristoren TH1, TH2 beziehungsweise TH3, TH4 gekennzeichnet. Jeder dieser Thyristoren TH1 bis TH 4 wird durch eine Halbleiterzelle 2 (vergleiche FIG 1 und FIG 4) realisiert.

Am Eingang des Vierpols liegt Spannung Vᵢₙ mit einer Frequenz fᵢₙ an. Der Ausgangsstrom ist durch Iₒᵤₜ gekennzeichnet.

Der erfindungsgemäße Aufbau des Leistungsmoduls ermöglicht eine verbesserte Kaltstartfähigkeit beziehungsweise erhöhte Starthäufigkeit bei gleicher Baugröße des Leistungsmoduls oder bei gleicher Kaltstartfähigkeit und Starthäufigkeit eine verringerte Baugröße des Leistungsmoduls. Dabei versteht man unter Kaltstartfähigkeit das maximale Lastkollektiv aus Strom und Zeit, welches mit einem sich bei definierter Umgebungstemperatur befindlichen Motorstarter realisiert werden kann, ohne dass eine Beschädigung des Halbleiterschaltelements durch Überschreiten der maximal zulässigen Sperrschichttemperatur auftritt. Unter der Starthäufigkeit versteht man das maximale Lastkollektiv aus Strom und Zeit des Motorhochlaufs, sowie der Zeit der Ein-Dauer und der Anzahl von Schaltvorgängen je Stunde (Zyklen je Zeiteinheit), welches mit einem sich bei definierter Umgebungstemperatur befindlichen Motorstarter realisiert werden kann, ohne dass eine Beschädigung des Halbleiterschaltelements durch Überschreiten der maximal zulässigen Sperrschichttemperatur auftritt.

## Patentansprüche

1. Elektronisches Leistungsmodul, insbesondere für ein elektronisches Motor-Steuergerät zum Sanftanlauf von Motoren, mit
- einer ersten und einer zweiten Kühleinrichtung (7 bis 12) und
- einer Halbleitereinrichtung (1), die zwischen der ersten und der zweiten Kühleinrichtung (7 bis 12) angeordnet ist,
**dadurch gekennzeichnet, dass**
- um die Halbleitereinrichtung (1) ein elastischer Ringkörper (6) angeordnet ist, wobei der Raum innerhalb des Ringkörpers (6), der teilweise von der ersten und zweiten Kühleinrichtung (7 bis 12) begrenzt wird und in dem sich die Halbleitereinrichtung (1) befindet, vergossen ist.

2. Elektronisches Leistungsmodul nach Anspruch 1, wobei die erste und zweite Kühleinrichtung (7 bis 12) jeweils mindestens einen Kühlkörper (9 bis 12) aufweisen.

3. Elektronisches Leistungsmodul nach Anspruch 1 oder 2, wobei die erste und/oder zweite Kühleinrichtung (7 bis 12) je eine Metallschiene (7, 8) zum unmittelbaren Wärmeabtransport von der Halbleitereinrichtung (1) und zum elektrischen Kontaktieren der Halbleitereinrichtung (1) aufweisen/aufweist.

4. Elektronisches Leistungsmodul nach Anspruch 3, wobei die jeweilige Metallschiene (7, 8) und der mindestens eine Kühlkörper (9 bis 12) einteilig sind.

5. Elektronisches Leistungsmodul nach Anspruch 3 oder 4, wobei die jeweilige Metallschiene (7, 8) und der mindestens eine Kühlkörper (9 bis 12) aus Kupfer und/oder Aluminium bestehen.

6. Elektronisches Leistungsmodul nach einem der vorhergehenden Ansprüche, wobei die Halbleitereinrichtung (1) zwei elektrisch antiparallel geschaltete Halbleiterelemente (TH1 bis TH4) aufweist.

7. Elektronisches Leistungsmodul nach Anspruch 6, wobei die Halbleiterelemente (TH1 bis TH4) als gehäuselose Halbleiterzellen (2) ausgeführt sind.

8. Elektronisches Leistungsmodul nach einem der vorhergehenden Ansprüche, wobei der Ringkörper (6) aus Gummi besteht.

9. Elektronisches Leistungsmodul nach einem der vorhergehenden Ansprüche, wobei der Ringkörper (6) in axialer Richtung eine im Wesentlichen konstante Abmessung aufweist, so dass zwischen der ersten und zweiten Kühleinrichtung (7 bis 12) eine vorgegebene Luft- und Kriechstrecke gewährleistet ist.

10. Elektronisches Leistungsmodul nach einem der vorhergehenden Ansprüche, wobei der Ringkörper (6) eine Öffnung oder Aussparung (17) aufweist, durch die Leitungen (3, 5) für eine Thyristor-Zündung durchgeführt sind und/oder durch die eine Vergussmasse (16) eingebracht ist.

11. Verfahren zum Herstellen eines elektronischen Leistungsmoduls, insbesondere für ein elektronisches Motor-Steuergerät zum Sanftanlauf von Motoren, durch
- Anordnen einer Halbleitereinrichtung (1) zwischen einer ersten und einer zweiten Kühleinrichtung (7 bis 12),
**gekennzeichnet, durch**
- Anordnen eines elastischen Ringkörpers (6) um die Halbleitereinrichtung (1), wobei sich ein Raum innerhalb des Ringkörpers (6), der teilweise von der ersten und zweiten Kühleinrichtung (7 bis 12) begrenzt wird und in dem sich die Halbleitereinrichtung (1) befindet, ergibt, und
- Ausgießen des Raums mit einer Vergussmasse (16).

12. Verfahren nach Anspruch 11, wobei der Ringkörper (6) die beiden Kühleinrichtungen (7 bis 12) vor dem Ausgießen derart beabstandet, dass zwischen der ersten und der zweiten Kühleinrichtung (7 bis 12) eine vorgegebene Luftoder Kriechstrecke gewährleistet ist.
